# EUROPÄISCHE PATENTSCHRIFT

(11) **EP 0 625 001 B1**
(45) Veröffentlichungstag und Bekanntmachung des Hinweises auf die Patenterteilung: **28.11.2001**
(21) Anmeldenummer: 94106537.7
(22) Anmeldetag: 27.04.1994
(51) Int. Cl.: H05K 3/34, G03F 7/40

(54) **Verfahren zum bildmässigen Metallisieren von strukturierten Leiterplatten**
Process for image-wise metallising structured printed circuit boards
Procédé de métallisation selon une image de plaques à circuit imprimé structurées

(30) Priorität: 13.05.1993 DE 4316087
(43) Veröffentlichungstag der Anmeldung: 17.11.1994
(73) Patentinhaber: Morton International, Inc., Chicago, Illinois 60606-1596 (US)
(72) Erfinder: Horn, Klaus, D-65719 Hofheim (DE); Lingnau, Jürgen, Dr., D-55130 Mainz-Laubenheim (DE); Schütze, Gerald, Dr., D-65719 Hofheim/Ts (DE); Hinter, Werner, D-65203 Wiesbaden (DE)
(74) Vertreter: Weber, Dieter, Dr.

(56) Entgegenhaltungen:
- EP-A- 0 418 733
- DE-A- 3 729 733
- US-A- 4 946 563

## Beschreibung

Die Erfindung betrifft ein Verfahren zum bildmäßigen, bevorzugt stromlosen Metallisieren von strukturierten Leiterplatten bzw. von gedruckten Schaltungen, die von einer Lötstoppmaske unter Aussparung von Lötaugen abgedeckt sind.

Derartige Schaltungen werden üblicherweise an den für Kontaktierungen vorgesehenen Anschlußsteilen einem Schwall- bzw. Wellenlötprozeß unterworfen, bei dem an den freiliegenden, nicht von der Lötstoppmaske abgedeckten Kontaktstellen Lötmetall abgeschieden wird, das später teils zum Verbinden von übereinanderliegenden Mehrlagenschaltungen, teils zum Anlöten von Bauelementen dient. Um eine ausreichende Resistenz der Lötstoppmaske unter den Bedingungen des Welleniötens und der weiteren Verarbeitungsschritte zu erreichen, ist es erforderlich, die lichtgehärtete Lötstoppmaske einer zusätzlichen thermischen Härtung zu unterwerfen. Dabei werden die in dieser Schablone enthaltenen thermisch vernetzbaren Verbindungen, z. B. Epoxyverbindungen, vernetzt und bilden so ein ausreichend resistentes Gebilde. In neuerer Zeit ist man mehr dazu übergeganten, die Kontaktstellen statt durch Wellenlöten durch stromlose Metallabsoneidung, inspesongere von Zinn, Nickel oder Gold, aus entsprechenden Bädern herzustellen. Dieses Verfahren hat den Vorteil, daß die abgeschiedenen Metallschichten dünner und wesentlich gleichmäßiger sind als beim Wellenlöten. Es wird besongers cann angewendet, wenn elektroniscne Bauteile direkt auf die Oberfläche der Leiterplatte montiert werden ("Service Mount Device" (SMD)-Technik), genn für diese Technik ist eine besongers gleichmäßige und flacne Oberfläche der Leiterplatten erforderlich. Dieses Erfordernis läßt sich durch Lötverfahren, z. B. durch Heißverzinnen, nicht erfüllen. Es zeigte sich aber, daß soicne Bäder dazu neigen, cie ausgehärtete Lötstoppmaske zu unterwandern, so daß sich unterhalb von deren Kanten Metall abscheidet. Diese Erscheinung ist unerwünscht und führt zur örtlichen Lockerung der Lötstoppmasken, die sich gegebenenfalls durch Abheben beim Klebebandtest zu erkennen gibt.

Aufgabe der Erfindung war es, ein Verfahren zum bildmäßigen Metallisieren einer durch eine Lötstoppmaske bildmäßig abgedeckten strukturierten Leiterplatte vorzuschlagen, das die Technik der stromlosen Metallisierung nutzt, ohne daß die Lötstoppmaske von der Metallisierungslösung unterwandert wird.

Diese Aufgabe wird durch das erfindungsgemäße Verfahren zum bildmäßigen Metallisieren von strukturierten Leiterplatten mit einer Kupferoberfläche darauf gelöst, bei dem die fertigstrukturierte Leiterplatte mit einer Lötstoppmaske unter Aussparung der Lötkontaktstellen bedeckt, die Lötstoppmaske thermisch gehärtet und an den freiliegenden Lötkontaktstellen Metall aus einem wäßrigen Bad abgeschieden wird, dadurch gekennzeichnet, daß man die Lötstoppmaske vor der Metallabscheidung unter solchen Bedingungen erwärmt, daß nur teilweise thermische Härtung erfolgt und die Kupferoberfläche der Leiterplatte praktisch nicht oxidiert wird und daß man die Maske nach der Metallabscheidung durch Erwärmen vollständig durchhärtet.

Die Metallabscheidung bei dem erfindungsgemäßen Verfahren erfolgt bevorzugt stromlos. Sie ist grundsätzlich auch galvanisch mit Hilfe des elektrischen Stromes möglich, jedoch ist hierbei der Kontaktanschluß schwieriger zu bewerkstelligen. Als abzuscheidende Metalle kommen insbesondere Zinn, Nickel, und Gold in Betracht.

Die erste Erwärmungsstufe, die vor der Metallabscheidung erfolgt, führt also zu einer unvollständigen thermischen Härtung der Lötstoppmaske. Diese Härtung reicht aus für die zur Metallabscheidung erforderliche Resistenz der Maske. Andererseits wird offenbar durch diese teilweise thermische Härtung die gute Haftung der Maske an der Oberfläche der Leiterplatte nicht oder nur in so geringem Maße gemindert, daß die Maske während der Metallabscheidung nicht unterwandert wird.

Es ist wesentlich, daß bei der ersten unvollständigen thermischen Härtung eine oxidative Veränderung der Kupferoberfläche der Leiterplatte erfolgt. Dies kann schon dadurch erreicht werden, daß die Härtung unter weniger drastischen Bedingungen als sonst üblich, also bei niedrigerer Temperatur oder nur über eine kürzere Zeit durchgeführ wird. Im allgemeinen dauert diese erste Härtung nicht länger als 15 min bei einer Temperatur im Bereich von etwa 100 bis 150 °C. Härtungszeiten von 5 bis 12 min werden bevorzugt. Mit Vorteil kann die Härtung unter Sauerstoffausschluß, z. B. in einer Schutzgasatmosphäre, z. B. aus Stickstoff oder Kohlendioxid, durchgeführt werden.

Die zweite Härtungsstufe bewirkt die vollständige Aushärtung der Lötstoppmaske. Sie erfordert je nach der Natur der härtbaren Mischung Temperaturen im Bereich von etwa 120 bis 180 °C und Zeiten von etwa 15 bis 90, bevorzugt 30 bis 80 min.

Geeignete Materialien für die Herstellung der Lötstoppmasken sind z. B. in der EP-A-418 733 und der älteren deutschen Patentanmeldung P 42 34 072.1 beschrieben, Solche Materialien weisen auf der fertigstrukturierten Leiterplatte eine Schicht aus einem photopolymerisierbaren Gemisch auf, das
a) eine Verbindung mit mindestens einer, bevorzugt mindestens zwei endständigen ethylenisch ungesättigten Gruppen, die durch radikalisch initiierte Additionskettenpolymerisation ein vernetztes Polymerisat zu bilden vermögen,
b) ein wasserunlösliches, in wäßrig-alkalischen Lösungen lösliches polymeres Bindemittel,
c) einen durch Strahlung aktivierbaren Polymerisationsinitiator oder eine Polymerisationsinitiatorkombination,
d) eine Verbindung, die mit sich selbst, mit dem Bindemittel (b) oder mit dem Polymerisat der Verbindung (a) in der Wärme zu vernetzen vermag,
e) ggf. einen durch Wärme aktivierbaren Vernetzungsinitiator für die Verbindung (d) und
f) ggf. ein feinteiiiges mineralisches Pigment enthält.

Als mineralisches Pigment sind vor allem Silikate oder Kieselsäuren geeignet. Der Mengenanteil des Pigments beträgt allgemein 20 bis 50, vorzugsweise 25 bis 40 Gew.-%.

Als monomere, polymerisierpare Verbindungen werden im allgemeinen Ester der Acryl- oder Methacryläsure mit menrwertigen, vorzugsweise primären, Alkoholen verwendet. Der Alkohol soilte bevorzugt mindestens zwei Hydroxygruppen enthalten, da durch mehrfaon ungesättigte Verbindungen die erwünschte Vernetzungswirkung erreicht wird. Die Ester des Trimethylolpropans, Trimethylolethans, des Pentaervthrits und Dipentaerythrits sind bevorzugte Beispiele. Das Monomere ist im allgemeinen in einer Menge von 10 bis 35, vorzugsweise von 15 bis 30 Gew.-%. bezogen auf den Gesamtgehait an nichtflüchtigen Bestandteilen, in dem Gemison enthalten.

Als polymere Bindemittel eignen sich vor allem Polymere mit seitenständigen Carboxyl- oder Carbonsäureanhydridgruppen. Besonders bevorzugt werden Copolymere der Acryl- und Methacrylsäure, die als Comonomere Acryl- oder Methacrylsäureester, Styrole, Acryl- oder Methacrylnitril, Acryl- oder Methacrylamid oder Vinylheterocyclen enthalten.

Als durch Strahlung aktivierbare Polymerisationsinitiatoren können zahlreiche Substanzen Verwendung finden. Beispiele sind Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Von Vorteil sind auch Photoinitiatoren, die durch Licht spaltbare Trihalogenmethylgruppen enthalten, insbesondere Verbindungen aus der Triazin- oder Thiazolinreihe.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemisches, zugesetzt.

Das erfindungsgemäße Gemiscn entnält ferner eine thermiscn vernetzbare Verbindung. Bevorzugt werden zwei- oder mehrwertige Epoxyverbindungen. Als Beispiele sind insbesondere Bisgiycidylether von zweiwertigen Alkoholen und Phenolen, wie z. B. von Bispnenol A, von Polyethylenglykol- und polypropylenglykolethern des Bisphenols A. von Butan-1,4-diol, Hexan-1,6-diol, Polyethylenglykol, Polypropylenglykol oder Polytetrahydrofuran geeignet.

Mit Vorteil können auch die in der älteren deutscnen Patentanmeldung P 42 34 072.1 beschriebenen cycloaliphatischen Epoxyverbindungen eingesetzt werden. Dies sind Verbindungen, die mindestens einen cycloaliphatischen Ring und mindestens eine Epoxygruppe enthalten, wopei die Epoxygruppen vorzugsweise nicht durch Chlorwasserstoffabspaltung aus einem Chlorhydrin entstanden sind.

Auch Bisglycidylether von dreiwertigen Alkoholen, z. B. von Glycerin, können verwendet werden. Die Epoxide werden dem Gemisch gewöhnlich in einer Menge von etwa 10 bis 30, vorzugsweise 12 bis 25 Gew.-%, bezogen auf die nichtflüchtigen Bestandteile des Gemisches, zugesetzt.

Als weitere thermisch vernetzbaren Verbindungen sind solche mit kondensationsfähigen N-Hydroxymethyl- oder N-Alkoxymethylgruppen geeignet. Beispiele sind Hexamethoxymethyl- und Hexahydroxymethylmelamin.

Wenn als Vernetzer Epoxyverbindungen eingesetzt werden, enthält das Gemisch bevorzugt einen Härter oder Additionsinitiator für Epoxygruppen. Der Härter ist bevorzugt eine Stickstoffbase, z. B. Triethylamin, 1,4-Diazabicyclo[2.2.2]octan (Dabco), Dibutylamin oder höher aikylierte Mono-, Di- und Triamine auf aliphatischer Basis. Die Menge der Base liegt im allgemeinen zwischen 0,15 und 1,5, vorzugsweise zwischen 0,2 und 1,0 Gew.-%.

Das Gemisch wird im allgemeinen in einem organischen Lösemittel gelöst und aus dieser Lösung auf die Oberfläche der strukturierten Leiterplatte, die normalerweise aus Kupferleiterbannen auf einer Isolierstoffplatte besteht, aufgebracht und getrocknet. Die weitere Verarbeitung erfolgt durch bildmäßige Belichtung der Schicht, wobei die Lötaugen abgedeckt werden, und Auswaschen der unbelichteten Schichtbereiche mit einem Entwickler.

Als Entwickler sind vorzugsweise waßrig-alkalische Lösungen, z. B. von Alkalihydroxiden, -carbonaten oder -silikaten, geeignet, denen gegebenenfalls kleine Mengen, z. b. bis zu 10 Gew.-%, an mit Wasser mischbaren organischen Lösemittein oder Netzmitteln zugesetz: werden können.

Fertig entwickelte Lötmasken des beschriebenen Typs werden vor dem Lötprozeß einer Temperaturbehandlung unterzogen. Dabei reagieren z. B. die Carboxylgruppen des Bindemittels mit dem mehrfunktionellen Epoxid zu einem interpenetrierenden Netzwerk. Integrierender Bestandteil dieses Netzwerkes ist auch der mineralische Feststoff.

Bei dem erfindungsgemäßem Verfahren erfolgt diese Wärmebehandlung in zwei Stufen. Dabei ist es entscheidend, daß die erste Stufe unter solchen Bedingungen erfolgt, daß die Kupferoberfläche noch nicht oder nicht in nennenswertem Maße oxydiert wird. Wann dies der Fall ist, läßt sich im einzelnen durch einfache Versuche ermitteln. In der Regel ist, wie oben erwähnt, eine Behandlung von weniger als 15 Minuten bei 150 °C unschädlich. Die Gefahr der Oxydation wird durch Sauerstoffausschluß weiter gemindert; die angegebenen Regelwerte können daher in vielen Fällen auch ohne Nachteil überschritten werden. Andererseits sollte eine thermische Härtung bis zu einem gewissen Mindestgrad erfolgen, da dann die Resistenz der Masken gegenüber den Metallisierungsbädern, die man gewöhnlich bei erhöhter Temperatur, etwa zwischen 50 und 100 °C, einwirken läßt, besser ist. Masken, die überhaupt nicht thermischisch vorgehärtet sind, werden in diesen Bädern leicht ausgelaugt und die Bäder durch die entsprechenden löslichen Schichtbestandteile verunreinigt. In der Regel sollte eine Härtung von etwa 5 bis 12 Minuten bei einer Temperatur im Bereich von etwa 120 bis 150 °C vorgenommen werden.

Anschließend erfolgt die Metallisierung in an sich bekannter Weise mit handelsüblichen Metallisierungsbädern, wobei der Metallisierung gewöhnlich noch verschiedene Reinigungs- und Anätzschritte vorausgehen. Als Metallisierungsbäder werden insbesondere Zinn-, Nickel- und bzw. oder Goldbäder eingesetzt. Geeignete Bäder und Verfahren sind z. B. in "^{(R)} Nimuden - Chemisch Nickel für anspruchsvolle Anwendungen" von Dr. Schenzel, Degussa-Hausmitteilungen, 1992; "Electroless Plating Fundamentals And Applications" von Glenn O. Mallory, American Electroplaters and Surface Finisher Society, 1990; und "Gold als Oberfläche" von F.H. Reid und W. Goldie, Leuze-Verlag, Saulgau, 1982, beschrieben.

Die zweite thermische Härtungsstufe folgt danach in wiederum üblicher Weise in dem oben erwähnten Umfang. Die Platte kann dann in bekannter Weise mit elektronischen Bauelementen bestückt werden.

Die folgenden Beispiele erläutern die Durchführung des erfindungsgemäßen Verfahrens. Wenn nichts anderes angegeben ist, sind Prozentzahlen und Mengenverhältnisse in Gewichtseinheiten zu verstehen. Die Mengen sind zumeist in Gewichtsteilen (Gt) angegeben.

### Beispiel 1

In einem zylindrischen Gefäß wurden in 123,9 Gt 3-Methoxy-butanol-1
112,5 Gt Pentaerythrit-triacrylat,
128,9 Gt Trimethylolpropan-triacrylat,
27,5 Gt 9-Phenylacridin,
12,4 Gt Neozapongrün,
1,2 Gt eines blauen Azofarbstoffs,
2,5 Gt Triethylendiamin
mit einem hochtourigen Schneilrührer in Lösung gebracht. Dann wurden im Verlauf von 30 Minuten 396.7 Gt eines silikatischen Pigments, das ein natürliches Agglomerat von korpuskularem Quarz und laminarem Kaolinit ist, in die gerührte Lösung eingestreut. Dieser Suspension wurden anschließend 694,2 Gt einer 53 %-igen Lösung eines Terpolymeren aus Styrol, Methacrylsäure und n-Hexylmethacrylat (32 : 15 : 3) zugesetzt und die Mischung gut homogenisiert.

Der viskose Lack wurde in einer Glaskugelmühle vermahlen und dann durch ein 160 *µ*m V2A-Gewebe-Druckfilter filtriert und abgefüllt.

252 Gt eines epoxydierten Phenol-Formaldehyd-Harzes mit dem Epoxid-Äquivalentgewicht 172 bis 179 wurden in 148 Gt 3-Methoxybutanol mittels eines Ankerrührers gelöst. Nach 15 Minuten Rührzeit lag eine klare Lösung mit 63 % Feststoffgehalt vor.

100 Gt der ersten Lösung wurden mit 22,3 Gt der Epoxidharzlösung intensiv gemischt. Der Feststoffgehait der Mischung betrug 67,5 %.

Eine 24 x 36 cm große Platte aus Epoxidharz-Glasgewebe mit einem beidseitig aufgebrachten Schaltbild aus 0,2 bis 1,5 mm breiten und 50 bis 90 *µ*m dicken Kupferbahnen und durchkontaktierten Bohrungen wurde mit der vorstehend beschriebenen Lösung mittels einer halbautomatischen Siebdruckmaschine vollflächig beschichtet. Die so beschichtete Leiterplatte wurde 5 Minuten bei Raumtemperatur belassen und anschließend 7 Minuten in einem Umlufttrockenschrank bei 80 °C getrocknet. Nach dem Abkühlen auf Raumtemperatur wurde die beschichtete Leiterplatte durch eine Filmvoriage bildmäßig belichtet.

Entwickelt wurde innernalb 90 s in einer Durchlaufsprühanlage mit 1 %-iger wäßriger Sodalösung bei 30 °C mit 1,2 bar Sprühdruck.

Nach Waschen mit Wasser wurde die entwickelte Platte in einem Warmiuftdurchlauftrockner getrocknet und anschließend in einem Umlufttrockenofen 10 Minuten bei 150 °C getempert. Die teilweise ausgenärtete Platine wurge wie folgt benandelt:

Sie wurde 3 Minuten bei Raumtemperatur in ein handelsübliches saures Reinigungsbad (pH < 1) getaucht, mit Wasser gespült, dann 2 Minuten bei Raumtemperatur in ein handelsübliches Mikroätzbad (pH <1) getaucht, wiederum gespült, in 3 %iger Schwefelsäure bei Raumtemperatur 1 Minute dekapiert, nochmals gespült, 5 Minuten in PdCl₂-Lösung aktiviert, gespült, dann wieder 1 Minute in 3 %iger Schwefelsäure bei Raumtemperatur dekapiert, danach 30 Minuten bei 65 °C in einem handelsüblichen Nickelbad (pH 5,5) behandelt, nochmals gespült und getrocknet. Nach dieser Behandlung war eine 5 *µ*m dicke Nickelschicht auf den freigelegten Kontaktstellen abgeschieden. Die Nickelabscheidung war exakt durch die Lötstoppmaske begrenzt, es waren keine Unterwanderungen an den Rändern zu erkennen. Wenn ein handelsübliches druckempfindliches Klebeband auf die Randzone der Lötstoppmaske aufgepreßt und dann ruckartig abgerissen wurde, blieb die Maske unbeschädigt auf der Leiterplatte haften. Anschließend wurde die Platte durch 1 Stunde Erwärmen auf 150 °C vollständig ausgehärtet.

Es wurden insgesamt 10 Platten in den gleichen Bädern behandelt. Die Bäder zeigten danach keinerlei Verfärbung oder Verunreinigung.

### Vergleichsbeispiel 1

Eine gedruckte Schaltung wurde, wie in Beispiel 1 beschriepen, durch Photoresisttechnik hergestellt. Sie wurde nach dem Entwickeln 1 Stunde auf 150 °C erwärmt, wonach die Lötstoppmaske vollständig ausgehärtet war. Auf der Platte wurde dann in gleicher Weise wie in Beispiel 1 eine 5 *µ*m dicke Nickelschicht abgeschieden. Unter den Rängern der Maske hatte sich in unregelmäßiger Breite Nickel abgeschieden. Mit dem in Beispiel 1 angegebenen Klebebandtest wurden Teile der Randzonen der Maske von der Unterlage entfernt.

Die Bäder waren nach einer Behandlung von 10 in gleicher Weise vorbehandelten Platten weder verfärbt noon verunreinigt.

### Vergleichsbeispiel 2

Eine gedruckte Schaltung wurde, wie in Beispiel 1 beschrieben, hergestellt. Sie wurde jedoch nach dem Entwickeln und vor der Metallabscheidung keiner

Wärmebehandlung unterworfen. Wie in Beispiel 1 wurde eine 5 *µ*m dicke Nickelschicht abgeschieden. Die Platte wurde dann 1 Stunde bei 150 °C ausgehärtet.

Es war keine Unterwanderung der Maske durch abgeschiedenes Nickel zu erkennen. Auch im Klebebandtest blieb die Maske unbeschädigt.

Nach der Behandlung von 10 Platten in den gleichen Bädern waren diese, insbesondere das Nickelbad, deutlich verfärbt und getrübt, was auf herausgelöste Bestandteile der ungehärteten Lötstoppmaske zurückzuführen war.

### Beispiel 2

Eine gedruckte Schaltung wurde hergestellt und zur Metallisierung vorbereitet, wie es im Beispiel 1 beschrieben ist. Die Vernickelung erfolgte in einem handelsüblichen Nickelbad, das 7 g/l Ni und 32 g/l Hypopnosphit enthielt und ein pH von 4,8 hatte. Nach 20 Minuten Tauchen in das 90 °C warme Bad waren 5 *µ* m Nickel abgeschieden. Nach Spülen wurde die Platte in ein handelsübliches Goldbad getaucnt, das 4 g Au/l enthielt und ein pH von 4,0 hatte. Die Platte wurde 20 Minuten in das 85 °C warme Goldbad getaucht, wonach eine Goldschicht von 0,1 *µ*m abgeschieden war.

Die Platte wurde wie in Beispiel 1 vor dem stromiosen Vernickeln und Vergolden 10 Minuten auf 150 °C erwärmt. Nach der Metallabscheidung waren keine Unterwanderungen der Lötstoppmaske zu erkennen. Diese blieb im Klebebandtest unpeschädigt. Die Bäder zeigten auch nach der Verarbeitung von 10 Platten keine Verfärbung oder Verunreinigung.

### Vergleichsbeispiel 3

Eine gedruckte Schaltung wurde wie in Beispiel 2 beschrieben hergestellt, vernickelt und vergoldet. Jedoch wurde die Platte - analog Vergleichsbeispiel 1 - vor der Metallisierung 1 Stunde auf 150 °C erwärmt. Ähnlich wie im Vergleichsbeispiel 1 hatten sich unterhalb der Kanten der Lötstoppmaske Nickel und Gold abgeschieden. Im Klebebandtest wurden Teile der Maske abgerissen. Die Bäder waren auch nach der Verarbeitung von 10 Platten nicht verfärbt oder verunreinigt.

### Vergleichsbeispiel 4

Wie in Beispiel 2 wurde eine gedruckte Schaltung hergestellt, vernickelt und vergoldet. In diesem Fall wurde aber - analog Vergleichsbeispiel 2 - vor der Metallisierung überhaupt keine Temperung der Platte vorgenommen. Wie in Beispiel 2 war keine Unterwanderung der Maske mit Metall erfolgt; im Klebebahndtest haftete die Maske fest an der Schaltung. Nach der Verarbeitung von 10 Platten waren das Nickel- und das Goldbad deutlich verfärbt und getrübt.

Ähnliche Ergebnisse wurden erhalten, wenn strukturierte, mit Lötstoppmasken abgedeckte Leiterplatten statt mit Nickel stromlos mit Zinn beschichtet wurden.

## Patentansprüche

1. Verfahren zum bildmäßigen Metallisieren von strukturierten Leiterplatten mit einer Kupferoberfläche darauf, bei dem die fertigstrukturierte Leiterplatte mit einer Lötstoppmaske unter Aussparung der Lötkontaktstellen bedeckt, die Lötstoppmaske thermisch gehärtet und an den freiliegenden Lötkontaktstellen Metall aus einem wäßrigen Bad abgeschieden wird, **dadurch gekennzeichnet, daß** man die Lötstoppmaske vor der Metallabscheidung unter solchen Bedingungen erwärmt, daß nur eine teilweise thermische Härtung erfolgt und die Kupferoberfläche der Leiterplatte praktisch nicht oxidiert wird, und daß man die Maske nach der Metallabscheidung durch Erwärmen vollständig durchhärtet.

2. Verfahren nach Anspruch 1, **dadurch gekennzeichnet, daß** man die Lötstoppmaske herstellt, indem man eine Schicht aus einem durch Belichten und durch Erwärmen härtbaren Gemisch auf die strukturierte Oberfläche aufbringt, bildmäßig unter Aussparung der Lötkontaktstellen belichtet und die unbelichteten Schichtbereiche durch Auswaschen mit einem Entwickler entfernt.

3. Verfahren nach Anspruch 1, **dadurch gekennzeichnet, daß** man das Metall stromlos aus dem wäßrigen Bad apscheidet.

4. Verfahren nach Anspruch 1 oder 3, **dadurch gekennzeichnet, daß** das Metall Zinn. Nickel ung/oder Gold ist.

5. Verfahren nach Anspruch 2, dadurch gekennnzeichnet, daß das durch Belichten und Erwärmen härtbare Gemisch
a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches polymeres Bindemittel,
c) einen durch Strahlung aktivierbaren Polymerisationsinitiator oder eine Polymerisationsinitiatorkombination,
d) eine Verbindung, die mit sich selbst, mit dem Bindemittel (b) oder mit dem Polymerisat der Verbindung (a) in der Wärme zu vernetzen vermag, und
e) ggf. einen durch Wärme aktivierbaren Vernetzungsinitiator für die Verbindung (d)
enthält.

6. Verfahren nach Ansprucn 5. **dadurch gekennzeichnet, daß** das Gemisch zusätzlich
f) ein feinteiliges mineralisches Pigment enthäit.

7. Verfahren nach Anspruch 1, **dadurch gekennzeichnet, daß** man die Lötstoppmaske vor der Metallabscheidung bis zu 15 Minuten auf eine Temperatur im Bereich von 100 bis 150 °C erwärmt.

8. Verfahren nach Anspruch 1 oder 7, **dadurch gekennzeichnet, daß** man die Lötstoppmaske vor der Metallabscheidung unter Sauerstoffausschluß erwärmt.

9. Verfahren nach Anspruch 8, **dadurch gekennzeichnet, daß** man die Lötstoppmaske vor der Metallabscheidung unter einer Schutzgasatmosphäre erwärmt.

10. Verfahren nach Anspruch 1, **dadurch gekennzeichnet, daß** man die Lötstoppmaske nach der Metallabscheidung 15 bis 90 Minuten auf eine Temperatur im Bereich von 120 bis 180 °C erwärmt.

## Claims

1. A method of image-wise metallisation of structured printed circuit boards with a copper surface thereon, in which the finished structured printed circuit board is covered with a solder resist mask with the soldering contact locations cut out, the solder resist mask is thermally hardened and metal is deposited from an aqueous bath at the exposed soldering contact locations, **characterised in that** the solder resist mask is heated prior to the metal deposit step under such conditions that only partial thermal hardening is effected and the copper surface of the printed circuit board is practically not oxidised, and the mask is completely hardened after the metal deposit step by heating.

2. A method according to claim 1 **characterised in that** the solder resist mask is produced by applying a layer comprising a mixture which is hardenable by exposure to light and by heating to the structured surface, exposing the layer in image-wise fashion with the soldering contact locations cut out, and removing the unexposed regions of the layer by washing off with a developer.

3. A method according to claim 1 **characterised in that** the metal is deposited in a current-less procedure from the aqueous bath.

4. A method according to claim 1 or claim 3 **characterised in that** the metal is tin, nickel and/or gold.

5. A method according to claim 2 **characterised in that** the mixture which is hardenable by exposure and heating includes
a) a compound with at least one terminal ethylenically unsaturated group which can form a cross-linked polymer by radically initiated addition chain polymerisation,
b) a water-insoluble polymer binding agent which is soluble in aqueous-alkaline solutions,
c) a radiation-activatable polymerisation initiator or a polymerisation initiator combination,
d) a compound which is capable of cross-linking with itself, with the binding agent (b) or with the polymer of compound (a) in heat, and
e) possibly a heat-activatable cross-linking initiator for the compound (d).

6. A method according to claim 5 **characterised in that** the mixture additionally contains
f) a finely divided mineral pigment.

7. A method according to claim 1 **characterised in that** the solder resist mask is heated prior to the metal deposit step for up to 15 minutes to a temperature in the range of 100 to 150°C.

8. A method according to claim 1 or claim 7 **characterised in that** the solder resist mask is heated prior to the metal deposit step with the exclusion of oxygen.

9. A method according to claim 8 **characterised in that** the solder resist mask is heated prior to the metal deposit step under a protective gas atmosphere.

10. A method according to claim 1 **characterised in that** the solder resist mask is heated after the metal deposit step for 15 to 90 minutes to a temperature in the range of 120 to 180°C.

## Revendications

1. Procédé de métallisation selon l'image de cartes imprimées structurées présentant une surface de cuivre, dans lequel la carte imprimée structurée finie est recouverte d'une réserve de soudure, avec épargne des points de contact de soudure, la réserve de soudure est soumise à un durcissement thermique, et un métal, provenant d'un bain aqueux, est déposé sur les points de contact dégagés, **caractérisé en ce qu'**on chauffe la réserve de soudure avant dépôt du métal dans des conditions telles qu'il n'en résulte qu'un durcissement thermique partiel, et que la surface de cuivre de la carte imprimée ne soit pratiquement pas oxydée, et aussi que l'on soumet à un durcissement complet, par chauffage, la réserve après dépôt du métal.

2. Procédé selon la revendication 1, **caractérisé en ce qu'**on réalise la réserve de soudure en appliquant sur la surface structurée une couche d'un mélange pouvant durcir par exposition à la lumière et par chauffage, en éclairant la couche selon l'image en épargnant les points de contact de soudure, et en enlevant par lavage avec un révélateur les zones non-éclairées de la couche.

3. Procédé selon la revendication 1, **caractérisé en ce qu'**on dépose le métal sans courant à partir du bain aqueux.

4. Procédé selon la revendication 1 ou 3, **caractérisé en ce que** le métal est l'étain, le nickel et/ou l'or.

5. Procédé selon la revendication 2, **caractérisé en ce que** le mélange pouvant durcir par exposition à la lumière et chauffage contient
a) un composé ayant au moins un groupe terminal à insaturation éthylénique, à même de former un polymère réticulé par polymérisation radicalaire en chaîne par addition,
b) un liant polymère, insoluble dans l'eau, soluble dans les solutions hydro-alcalines,
c) un amorceur de polymérisation ou une combinaison d'amorceurs de polymérisation activables par rayonnement,
d) un composé qui peut à chaud se réticuler à soi-même, avec le liant (b) ou avec le polymère du composé (a), et
e) éventuellement un amorceur de réticulation, activable à la chaleur, pour le composant (d).

6. Procédé selon la revendication 5, **caractérisé en ce que** le mélange contient en outre
f) un pigment minéral finement divisé.

7. Procédé selon la revendication 1, **caractérisé en ce que**, avant dépôt du métal, on chauffe pendant un laps de temps allant jusqu'à 15 minutes la réserve de soudage à une température comprise entre 100 et 150°C.

8. Procédé selon la revendication 1 ou 7, **caractérisé en ce qu'**on chauffe la réserve de soudure avant dépôt du métal, à l'abri de l'oxygène.

9. Procédé selon la revendication 8, **caractérisé en ce qu'**on chauffe la réserve de soudure avant dépôt du métal, sous une atmosphère d'un gaz protecteur.

10. Procédé selon la revendication 1, **caractérisé en ce que**, après le dépôt du métal, on chauffe la réserve de soudure pendant 15 à 90 minutes à une température comprise entre 120 et 180°C.
